# EUROPEAN PATENT SPECIFICATION

(11) **EP 3 035 375 B1**
(45) Date of publication and mention of the grant of the patent: **03.05.2017**
(21) Application number: 14199222.2
(22) Date of filing: 19.12.2014
(51) Int. Cl.: H01L 21/67, H01L 21/677, C03C 17/00, C23C 18/16, C23C 18/38, C23C 18/18

(54) **TREATING MODULE OF AN APPARATUS FOR HORIZONTAL WET-CHEMICAL TREATMENT OF LARGE-SCALE SUBSTRATES**
BEARBEITUNGSMODUL EINER VORRICHTUNG ZUR HORIZONTALEN UND NASS-CHEMISCHEN BEARBEITUNG VON GROSSFLÄCHIGEN SUBSTRATEN
MODULE DE TRAITEMENT D'UN APPAREIL POUR TRAITER CHIMIQUEMENT ET HORIZONTALEMENT DES SUBSTRATS DE GRANDE TAILLE

(43) Date of publication of application: 22.06.2016
(73) Proprietor: Atotech Deutschland GmbH, 10553 Berlin (DE)
(72) Inventor: Hahn, Roland, 90482 Nürnberg (DE); Thomas, Christian, 91058 Erlangen (DE); Nößner, Martin, 90530 Wendelstein (DE); Ott, Thomas, 91189 Rohr (DE); Lorenz, Olaf, 90518 Altdorf (DE)

(56) References cited:
- JP-A- 2010 199 150

## Description

### Field of the Invention

The present invention relates to a treating module of an apparatus for horizontal wet-chemical treatment of large-scale substrates, in particular glass substrates, comprising a housing with a housing cover; a transport device comprising a plurality of transport elements for horizontal processing of large-scale substrates, wherein the treating module further comprises at least a first liquid nozzle and at least a gas nozzle arranged above the transport level of the large-scale substrates at the entry of the treating module and at least another first liquid nozzle and at least another gas nozzle arranged above the transport level of the large-scale substrates at the exit of the treating module for accumulating treatment liquid inside of the treating module, wherein each gas nozzle is arranged more exterior than the respective first liquid nozzle; and at least a liquid weir arranged below each first liquid nozzle below the transport level of the large-scale substrates.

The present invention is further directed to a method for treating of large-scale substrates in a horizontal apparatus comprising a plurality of modules, wherein such a treating module of the present invention is comprised.

### Backaround of the Invention

Devices and apparatuses for horizontal processing of substrates in the electronics industry are well known since decades. Originally, relatively thick printed circuit boards have been transported through such horizontal apparatuses in order to treat them with different process liquids. Such a treatment can comprise all required process steps to produce a printed circuit board for the industry. Said required process steps have included various pretreatment process steps like etching, rinsing, deposition of copper seed layers or the like; followed by at least a main process step of depositing metal, commonly copper, nickel or tin, on the surface of said pretreated substrate by an electroless or galvanic process step; and finally various posttreatment steps, such as rinsing, drying or the like.

However, the electronics industry is now demanding for devices and apparatuses suitable to process large-scale substrates, which are not only much larger than the conventional printed circuit boards, but which are also very often be composed of fragile glass material instead of the commonly used polymeric materials for printed circuit boards. There is a market trend to demand apparatuses suitable to transport and process large-scale glass substrates, such as flat panel displays, for the electronics industry, such as for the production of large-scale televisions.

An arising challenge for these large-scale substrates is also to provide and ensure a uniform treatment, in particular a uniform metal deposition on the surface of such large substrates without generating inhomogeneity.

JP 2010 199150 A of Tokyo Electron LTD discloses a substrate processing apparatus comprising a substrate transfer path, a first treatment liquid supply means, a gas supply means, a first rinse means and a second rinse means for treating a respective substrate, which is transferred through the substrate transfer path.

It is not possible to simply making use of the well-known apparatuses of the printed circuit board industry for this purpose. Said horizontal apparatuses, which have been successfully used in the past for the production of printed circuit boards, cannot fulfill these new demands for processing large-scale substrates, in particular glass substrates such as flat panel displays.

### Objective of the present Invention

In view of the prior art, it was thus an object of the present invention to provide a treating module of a horizontal apparatus suitable to transport and process large-scale substrates, in particular fragile large-scale glass substrates such as flat panel displays.

Furthermore, it was an object to provide a treating module of a horizontal apparatus for processing large-scale substrates, wherein a uniform surface treatment can be provided and ensured without generating inhomogeneity.

### Summary of the Invention

These objects and also further objects which are not stated explicitly but are immediately derivable or discernible from the connections discussed herein by way of introduction are achieved by a treating module having all features of claim 1. Appropriate modifications to the inventive treating module are protected in dependent claims 2 to 11. Further, claim 12 comprises a method for treating of large-scale substrates using such a treating module, whereas appropriate modifications of said inventive method are protected in dependent claims 13 and 14. Furthermore, claim 15 comprises the use of such a treating module for metal, in particular copper, deposition on large-scale glass substrates, in particular flat panel displays.

The present invention accordingly provides a treating module of an apparatus for horizontal wet-chemical treatment of large-scale substrates, in particular glass substrates, comprising a housing with a housing cover; a transport device comprising a plurality of transport elements for horizontal processing of large-scale substrates, wherein the treating module further comprises at least a first liquid nozzle and at least a gas nozzle arranged above the transport level of the large-scale substrates at the entry of the treating module and at least another first liquid nozzle and at least another gas nozzle arranged above the transport level of the large-scale substrates at the exit of the treating module for accumulating treatment liquid inside of the treating module, wherein each gas nozzle is arranged more exterior than the respective first liquid nozzle; at least a liquid weir arranged below each first liquid nozzle below the transport level of the large-scale substrates; characterized in that the treating module further comprises at least an adjusting device for adjusting the transport device and the liquid weirs of the treating module.

It is thus possible in an unforeseeable manner to provide a treating module of a horizontal apparatus, which is suitable to transport and process large-scale substrates, in particular fragile large-scale glass substrates such as flat panel displays.

Furthermore, the provision of an adjusting device in the inventive treating module supports together with the other essential components of said treating module that a uniform surface treatment can be provided and ensured without generating inhomogeneity.

### Brief Description of the Figures

For a more complete understanding of the present invention, reference is made to the following Detailed Description of the Invention considered in conjunction with the accompanying figures, in which:
**Fig. 1** exhibits a schematic perspective view of a treating module in accordance with an embodiment of the present invention.
**Fig. 2** exhibits a schematic perspective view of a treating module without housing cover in accordance with the same embodiment as shown in Figure 1 of the present invention.
**Fig. 3a** exhibits a schematic side view of a treating module with opened housing cover in accordance with the same embodiment as shown in Figure 1 of the present invention, while **Fig. 3b****,** **3c** **and** **3d** exhibit cross section views of different features of said treating module.
**Fig. 4** exhibits a schematic perspective view on the underside of a treating module in accordance with the same embodiment as shown in Figure 1 of the present invention.

### Detailed Description of the Invention

As used herein, the term "wet-chemical" treatment in accordance with the present invention refers to an electroless treatment without making use of current for achieving a metal deposition on a substrate. Such a wet-chemical treatment can be conducted by immersing the substrate in the treatment liquid, wherein a treatment liquid level is provided inside of the treating module, which is always above the upper surface of the substrate during processing; or by spraying treatment liquid on at least one surface of the substrate.

As used herein, the term "metal", when applied to an apparatus for horizontal wet-chemical treatment of a substrate in accordance with the present invention, refers to metals which are known to be suitable for such a horizontal deposition method. Such metals comprise gold, nickel, tin and copper, preferably copper.

As used herein, the term "large-scale substrate", when applied to a treating module in accordance with the present invention, refers to substrates of large dimensions as required for the production of flat panel displays, preferably up to at least Generation 8 dimensions (220 cm x 250 cm) for glass substrates.

The substrates are transported through a treatment area defined by the area between the first liquid nozzles of the treating module. The substrates are transported along a horizontal transport plane in a transport direction. The substrates are transported in such a manner that the substrates are transported through a treatment liquid which is accumulated in the treatment area.

A flow of treatment liquid is generated by the first liquid nozzles at the entry and at the exit of the treating module, which ejects the flow of the treatment liquid with a direction directed towards the treatment area.

A flow of gas is generated by the gas nozzle. The gas nozzle is spaced apart from the liquid nozzle along the transport direction by a gap. At least a part of the gas, which is ejected by the gas nozzle, escapes through the gap.

The combination of the first liquid nozzles and the gas nozzles are operative to remove or hold back treatment liquid from the substrate. It is not required that squeeze rollers be used which abut on a sensitive surface of the material. The flow of the treatment liquid ejected by the first liquid nozzles is operative to reduce outflow of treatment liquid through a clearance between the first liquid nozzles and the transport plane. The flow of the treatment liquid ejected by the first liquid nozzles also enhances an exchange of the treatment liquid at a surface of the substrate.

The gap between the gas nozzle and the respective first liquid nozzle allows the gas flow to remove the treatment liquid from the substrate outside of the treatment area, while providing a space through which the gas may escape without entering into the treatment area.

The term treatment liquid refers to any process chemical liquid to which the substrate may be subjected in such a treating module for wet-chemical treatment.

The upper surface of the substrate may be a sensitive surface. At least a major portion of the upper surface of the substrate should then not be brought into contact with rigid elements as the substrate enters or leaves the treatment area.

In one embodiment, the treating module further comprises two bearing retainer strips, preferably ball-bearing strips, comprising a plurality of bearings, preferably ball-bearings, for receiving the respective exterior ends of each transport element of the transport device.

In one embodiment, the treating module further comprises at least a second liquid nozzle arranged above the transport level of the large-scale substrate between the first liquid nozzles.

A treatment of such large-scale substrate in a treating module of the present invention can require such additional second liquid nozzles in order to provide enough treatment liquid to ensure a sufficiently high treatment liquid level inside of the treating module. If the dimensions of the large-scale substrate are becoming too large, it can happen that only the first liquid nozzles at the entry and the exit of the treating module cannot more provide enough treatment liquid to establish a treatment liquid level above the transport level of the substrates. It has to be ensured that also the upper surfaces of the processed substrates are constantly below the treatment liquid level.

In one embodiment, the liquid weir is arranged between two adjacent transport elements of the transport system below of the respective first liquid nozzle.

Such a liquid weir ensures that only a defined gap remains for the substrates for being transported through the entry and the exit of the treating module. At the same time, it minimizes treatment liquid loss from the treatment area inside of the treating module in conjunction with the first liquid nozzle.

In one embodiment, the treating module comprises a gas, preferably compressed air, delivery element arranged below the transport level of the large-scale substrate, wherein said gas delivery element is arranged below each gas nozzle of the treating module.

Such a gas delivery element ensures that only a defined gap remains for the substrate for being transported through the entry and the exit of the treating module. At the same time, it minimizes treatment liquid loss from the treatment area inside of the treating module in conjunction with the gas nozzle.

In one embodiment, the treating module further comprises at least a third bearing retainer strip, preferably ball-bearing strip, comprising a plurality of bearings, preferably ball-bearings, for receiving respective exterior ends of transport elements of the transport device, wherein said at least third bearing retainer strip is arranged parallel between the two bearing retainer strips.

Such additional bearing retainer strips become necessary if the dimensions of the large-scale substrate are too large for the commonly used transport elements like a roller or a wheel axis. Such transport elements lack the required accuracy in axial direction caused by constructional problems during their manufacturing. Rollers are normally composed of a metal core, such as a steel core, which is mechanically injected in an outer housing made of polymeric material. However, such an injection process generates very high mechanical forces leading to a technical limitation up to which axial length such transport elements can still be manufactured in the required accuracy. Thus, if the required axial length of a single transport element is not available due to the above-mentioned reasons, there is the possibility to install at least two transport elements one after another. This required then one additional bearing retainer strip at the axial interconnecting point between these two transport elements.

In one embodiment, the adjusting device comprises at least a first adjusting element and at least a second adjusting element, wherein the first adjusting elements are connected in such a manner to the respective liquid weirs or bearing retainer strips by a plurality of second adjusting elements that the horizontal alignment of said liquid weirs and bearing retainer strips can be adjusted.

This is highly advantageous for such processing of large-scale substrate, because it is very often challenging to manufacture module elements such as transport elements and liquid weirs in the lower part of the treating module with a sufficient accuracy for such substrates. Additional, there can always be an adjustment become necessary in order to properly horizontally align the aforementioned module elements. Such a selective adjustment is offered by the plurality of second adjusting elements, which enables a selective vertical movement (up or down, even in incremental extent) of the liquid weirs and bearing retainer strips perpendicular to the transport area of the treating module.

In one embodiment, the adjusting device is arranged below the bottom of the housing of the treating module in a separate area, which is substantially free of treatment liquid.

This is advantageous because any kind of adjusting device has often to be made of metal in order to provide enough mechanical stability. If the adjusting device is made of metal and the treatment liquid, such as for a wet-chemical copper deposition, can contact said adjusting device, copper will unintentionally be plated out on the surface of these metal parts.

In one embodiment, the first adjusting elements are bars or strips, which are forming together a racket as substructure for the treating module; wherein the second adjusting elements are bolts, pins or screws; and wherein both adjusting elements are preferably made of metal.

In one embodiment, the treating module further comprises at least a treatment liquid outlet element, which is a part of a separated treatment liquid circulation system of the treating module.

In one embodiment, the housing cover comprises a central area and two side areas, wherein the central area is aligned parallel to the transport area and comprises at least a gas discharge opening; and wherein both side areas running constantly downwards from the central area of the housing cover to the housing.

This is advantageous in cases, wherein a certain higher temperature above room temperature is set up for the treatment of the substrates inside of the treating module leading to evaporation process of components of the treatment liquid. The evaporated volatile components can be discharged from the treating module by the gas discharge opening. Additionally, the arrangement of the side walls supports that condensate which forms from the evaporated treatment liquid components will automatically flow back in the treatment liquid.

Further, the object of the present invention is also solved by a method for treating of large-scale substrates in a horizontal apparatus comprising a plurality of modules characterized by the following method steps:
i) Providing a horizontal apparatus comprising at least a pre-treatment module, at least an inventive treating module of the present invention, and at least a post-treatment module,
ii) Adjusting the transport elements and the liquid weirs of the inventive treating module of the present invention by the adjusting device to ensure their precise horizontal alignment,
iii) Providing large-scale substrates, preferably glass substrates,
iv) Transporting said large-scale substrates through the modules of the horizontal apparatus for executing pre-treatment, treatment, and post-treatment.

In a preferred embodiment of the method, the treatment of the large-scale substrates during method step iv) in the inventive treating module of the present invention is an electroless wet-chemical treatment for depositing a metal, preferably copper, on the surface of the large-scale substrates.

Such a wet-chemical treatment has been found advantageous in comparison to the known sputtering technique, which can only deliver copper layers of limited thickness. While sputtering finally produces copper layers of less than 1 µm, a wet-chemical treatment offers much thicker possible copper layers without generating the known bending effect caused by internal stress of the substrates, if the thick copper layers are sputtered.

A further advantage of such an inventive method is the possibility of forming directly selective copper layers on the surface of a substrate without the need first to deposit a copper layer on the entire surface of the substrate, which has then subsequently to be treated by various further method steps in order to generate selective copper layers. A deposit of selective palladium layers can become necessary for depositing such selective copper layers on the substrate in dependence of the material of the substrate itself. If the large-scale substrate is a glass substrate for flat panel displays, such a depositing of palladium layers with subsequent copper layers on the top of said palladium layers are preferred.

In a more preferred embodiment of the method, the electroless wet-chemical treatment is executed by immersing the large-scale substrate in the treatment liquid.

Immersing the substrate in treatment liquid offers the advantage of a uniform metal deposition in comparison to the known spraying technique of treatment liquid on the surface of substrates, which would generate non-uniform depositions caused by generating spraying patterns.

It has been additionally found that such an inventive treating module of the present invention can be used for metal, in particular copper, deposition on large-scale glass substrates, in particular flat panel displays.

The present invention thus addresses the problem of providing a treating module for a horizontal apparatus, which is suitable to transport and process large-scale substrates, in particular fragile large-scale glass substrates such as flat panel displays.

The following non-limiting examples are provided to illustrate an embodiment of the present invention and to facilitate understanding of the invention, but are not intended to limit the scope of the invention, which is defined by the claims appended hereto.

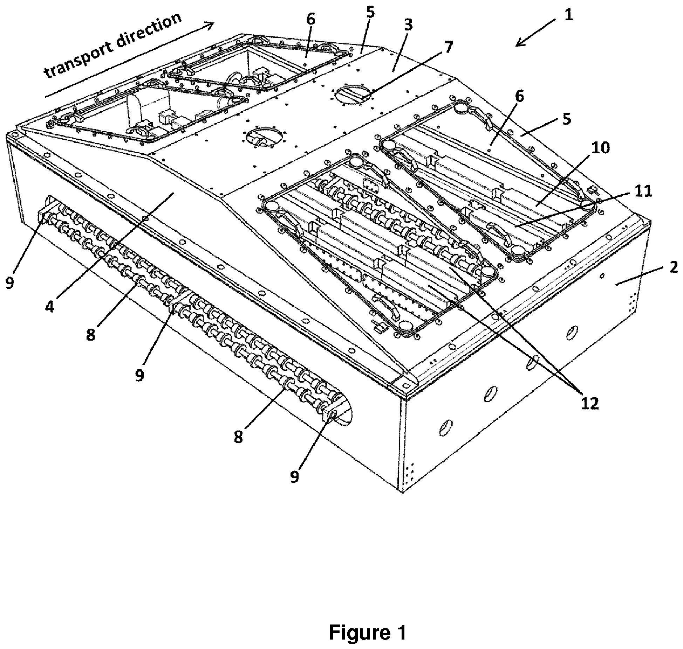

Turning now to the Figures, Figure 1 shows a schematic perspective view of a treating module 1 in accordance with an embodiment of the present invention.

Said treating module 1 comprises a housing 2 with a housing cover 4, wherein the housing cover 4 comprises a central area 3, two side areas 5, and two windows 6 in each two side areas 5. The central area 3 is herein aligned parallel to the transport area and comprises at least a gas discharge opening 7. Both side areas 5 are running constantly downwards from the central area 3 of the housing cover 4 to the housing 2.

The treating module 1 comprises further a transport device comprising a plurality of transport elements 8 for horizontal processing of large-scale substrates, wherein said transport elements 8 can be rollers or wheel axis. In the embodiment shown, each transport element 8 is a wheel axis. Rollers can be advantageous due to a less consumption of treatment chemicals caused by the less volume available inside of the treatment area of the treating module 1. The transport direction of the substrates is schematically shown in the Figure.

The treating module 1 further comprises two ball-bearing strips 9 comprising a plurality of ball-bearings for receiving the respective exterior ends of each transport element 8 of the transport device. Furthermore, the treating module 1 comprises a third ball-bearing strip 9 comprising a plurality of ball-bearings for receiving respective exterior ends of transport elements 8 of the transport device, wherein said at least third ball-bearing strip 9 is arranged parallel between the two ball-bearing strips 9.

The treating module 1 further comprises a first liquid nozzle 11 and a gas nozzle 10 arranged above the transport level of the large-scale substrates at the entry and at the exit of the treating module 1 for accumulating treatment liquid inside of the treating module 1, wherein each gas nozzle 10 is arranged more exterior than the respective first liquid nozzle 11. Furthermore, the treating module 1 comprises two second liquid nozzles 12 arranged above the transport level of the large-scale substrates between the two first liquid nozzles 11.

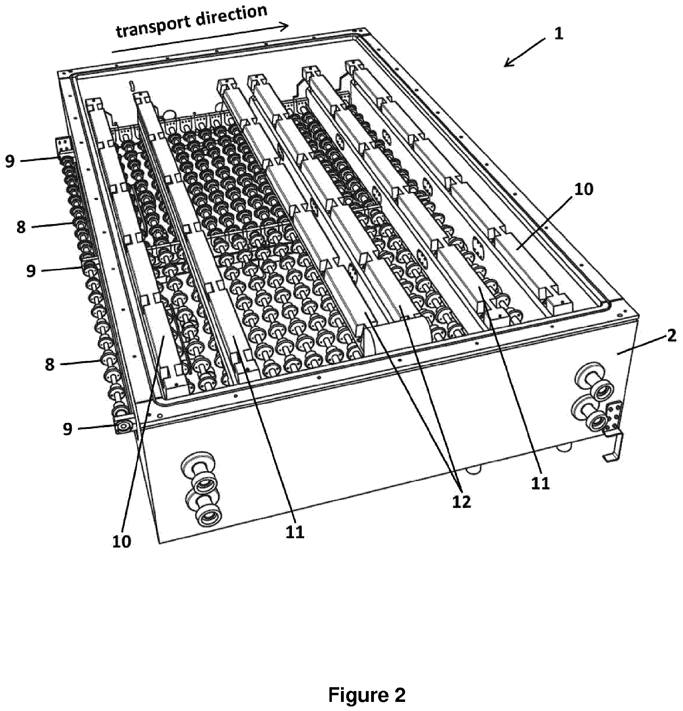

Figure 2 shows a schematic perspective view of a treating module 1 without housing cover 4 in accordance with the same embodiment as shown in Figure 1 of the present invention. Figure 2 is intended to illustrate in more detail the treating module 1 features above the transport level of the substrates. The respective treating module 1 features together with their corresponding reference signs are identical to the ones aforementioned for Figure 1 and will be not discussed again to avoid unnecessary repetition.

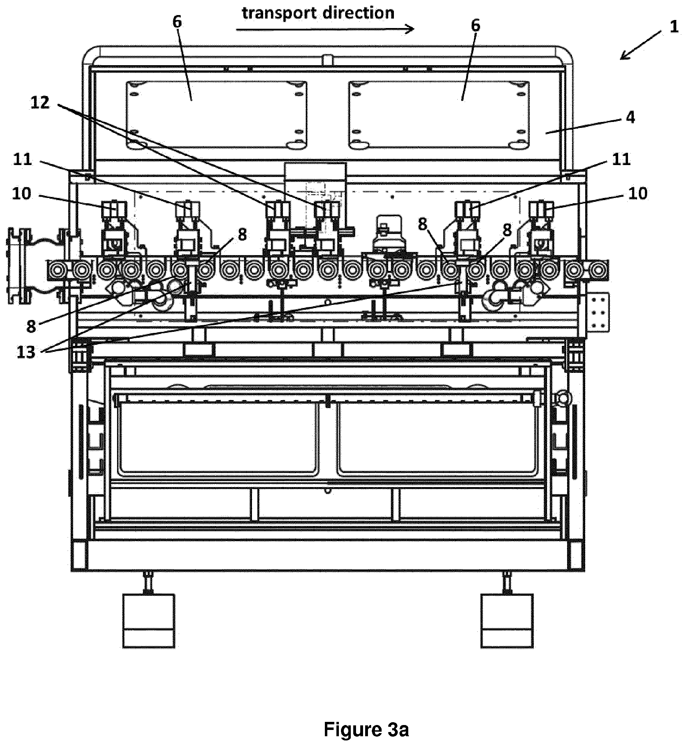

Figure 3a shows a schematic side view of a treating module 1 with opened housing cover 4 in accordance with the same embodiment as shown in Figure 1 of the present invention.

This alternative view of the treating module 1 illustrates the consequence of gas nozzle 10, first liquid nozzle 11, two second liquid nozzles 12, first liquid nozzle 11 and again gas nozzle 10 above the transport level of the substrates in transport direction.

Furthermore, the treating module 1 comprises two liquid weirs 13, which are arranged between two adjacent transport elements 8 of the transport system below of the respective first liquid nozzles 11.

The treating module 1 further comprises a gas delivery element 22 arranged below the transport level of the large-scale substrates, wherein said gas delivery element is arranged below each gas nozzle 10 of the treating module 1.

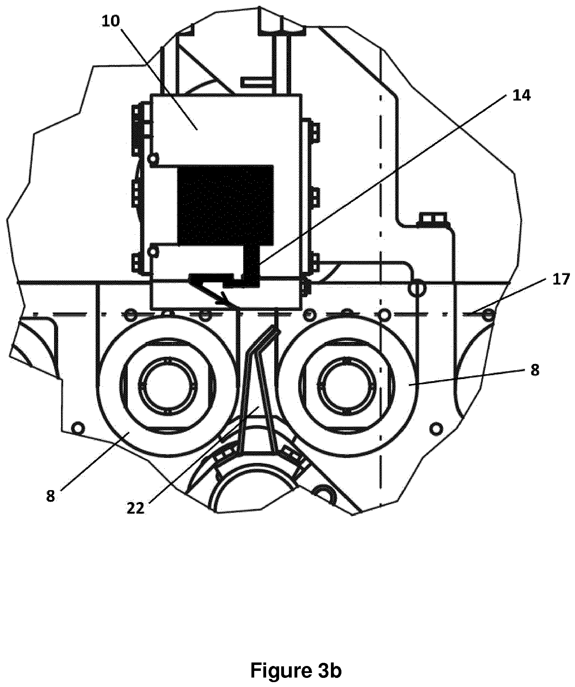

Figure 3b exhibits a cross section view of the site of the treating module 1 comprising a gas nozzle 10 in order to offer an enlarged view on the detailed arrangement at this site of the treating module 1. A gas delivery element 22 is provided directly below the gas nozzle 10 and below the transport level 17 of the large-scale substrates. Said gas delivery element 22 is arranged between two adjacent transport elements 8. The gas feed 14 of the gas nozzle 10 is bold black highlighted in order to clarify the pathway of the ejected gas flow at the entry and exit of the treating module 1, which is directed to the inside of the treatment area to support accumulating the treatment liquid inside of the treatment area.

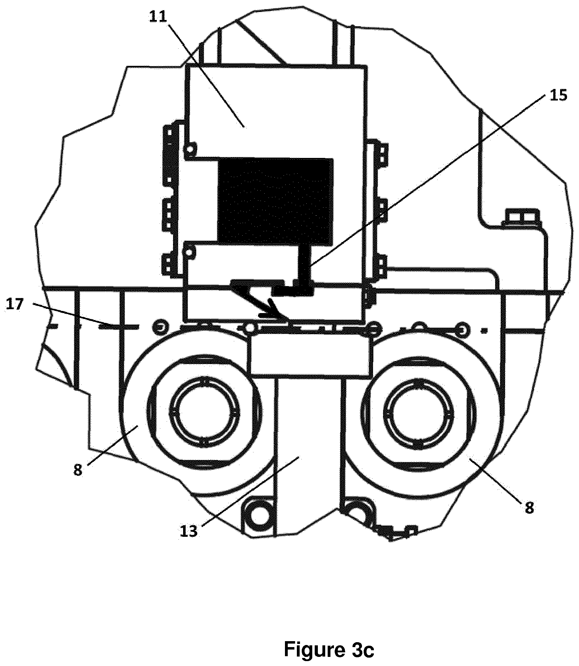

Figure 3c exhibits a cross section view of the site of the treating module 1 comprising a first liquid nozzle 11 in order to offer an enlarged view on the detailed arrangement at this site of the treating module 1. A liquid weir 13 is provided directly below the first liquid nozzle 11 and below the transport level 17 of the large-scale substrates. Said liquid weir 13 is arranged between two adjacent transport elements 8. The liquid feed 15 of the first liquid nozzle 11 is bold black highlighted in order to clarify the pathway of the ejected liquid flow at the entry and exit of the treating module 1, which is directed to the inside of the treatment area to support accumulating the treatment liquid inside of the treatment area.

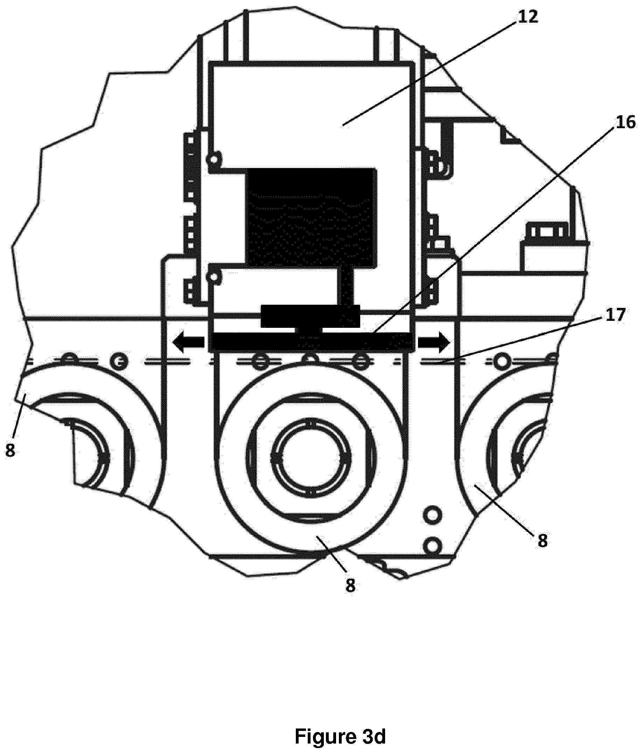

Figure 3d exhibits a cross section view of the site of the treating module 1 comprising a second liquid nozzle 12 above the transport level 17 of the large-scale substrates in order to offer an enlarged view on the detailed arrangement at this site of the treating module 1. The liquid feed 16 of the second liquid nozzle 12 is bold black highlighted in order to clarify the pathway of the ejected liquid flow inside of the treating module 1 between the two first liquid nozzles 11. Said ejected liquid flow, which is ejected parallel to the transport direction above the transport level 17 of the large-scale substrates, is supposed to ensure a sufficient treatment liquid level inside of the treating module 1.

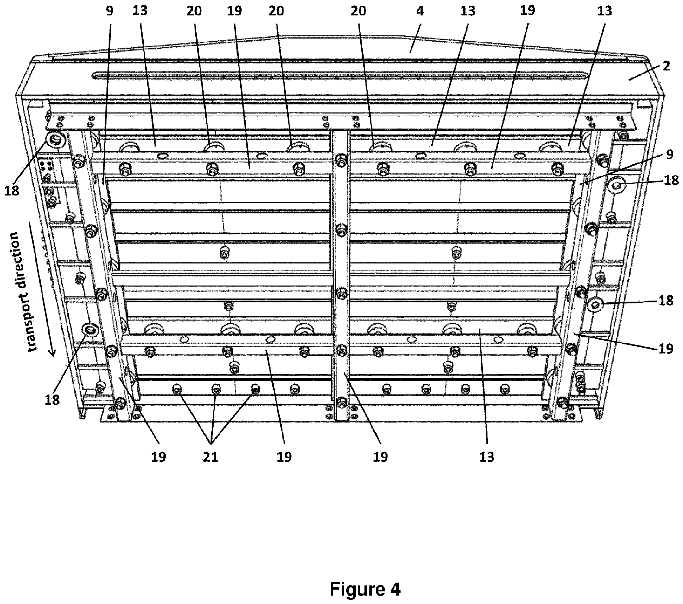

Figure 4 shows a schematic perspective view on the underside of a treating module 1 in accordance with the same embodiment as shown in Figure 1 of the present invention. Especially, the details of the adjusting device of the treating module 1 are supposed to be illustrated and clarified by this Figure 4.

Said adjusting device comprises in this preferred embodiment two parallel first adjusting elements 19 and three second adjusting element 20, which are running perpendicular to each other. The first adjusting elements 19 are bars, which are forming together a racket as substructure for the treating module 1. The second adjusting elements 20 are bolts. Both adjusting elements 19, 20 are made of metal.

The first adjusting elements 19 are connected in such a manner to the respective liquid weirs 13 or ball-bearing strips 9 by a plurality of second adjusting elements 20 that the horizontal alignment of said liquid weirs 13 and ball-bearing strips 9 can be adjusted. Herein, the adjusting device is arranged below the bottom of the housing 2 of the treating module 1 in a separate area, which is substantially free of treatment liquid.

The treating module 1 further comprises a plurality of treatment liquid outlet elements 18, which are a part of a separated treatment liquid circulation system (not shown) of the treating module 1. The treating module 1 further comprises a plurality of liquid feeds 21 of the respective gas delivery elements 22 (not shown).

It will be understood that the embodiments described herein are merely exemplary and that a person skilled in the art may make many variations and modifications without departing from the scope of the invention. All such variations and modifications, including those discussed above, are intended to be included within the scope of the invention as defined by the appended claims.

### Reference signs

- 1: Treating module
- 2: Housing
- 3: Central area of the housing cover
- 4: Housing cover
- 5: Side area of the housing cover
- 6: Window of the housing cover
- 7: Gas discharge opening
- 8: Transport element
- 9: Bearing retainer strip
- 10: Gas nozzle
- 11: First liquid nozzle
- 12: Second liquid nozzle
- 13: Liquid weir
- 14: Gas feed of the gas nozzle
- 15: Liquid feed of the first liquid nozzle
- 16: Liquid feed of the second liquid nozzle
- 17: Transport level of the large-scale substrates
- 18: Treatment liquid outlet element
- 19: First adjusting element
- 20: Second adjusting element
- 21: Liquid feed of the gas delivery element
- 22: Gas delivery element

## Claims

1. Treating module (1) of an apparatus for horizontal wet-chemical treatment of large-scale substrates, in particular glass substrates, comprising a housing (2) with a housing cover (4); a transport device comprising a plurality of transport elements (8) for horizontal processing of large-scale substrates, wherein the treating module (1) further comprises at least a first liquid nozzle (11) and at least a gas nozzle (10) arranged above the transport level (17) of the large-scale substrates at the entry of the treating module (1) and at least another first liquid nozzle (11) and at least another gas nozzle (10) arranged above the transport level (17) of the large-scale substrates at the exit of the treating module (1) for accumulating treatment liquid inside of the treating module (1), wherein each gas nozzle (10) is arranged more exterior than the respective first liquid nozzle (11); at least a liquid weir (13) arranged below each first liquid nozzle (11) below the transport level (17) of the large-scale substrates; **characterized in that**
the treating module (1) further comprises at least an adjusting device for adjusting the transport device and the liquid weirs (13) of the treating module (1).

2. Treating module according to claim 1 **characterized in that** the treating module (1) further comprises two bearing retainer strips (9), preferably ball-bearing strips, comprising a plurality of bearings, preferably ball-bearings, for receiving the respective exterior ends of each transport element (8) of the transport device.

3. Treating module according to claims 1 or 2 **characterized in that** the treating module (1) further comprises at least a second liquid nozzle (12) arranged above the transport level (17) of the large-scale substrates between the first liquid nozzles (11).

4. Treating module according to one of the preceding claims **characterized in that** the liquid weir (13) is arranged between two adjacent transport elements (8) of the transport system below of the respective first liquid nozzle (11).

5. Treating module according to one of the preceding claims **characterized in that** the treating module (1) comprises a gas, preferably compressed air, delivery element (22) arranged below the transport level (17) of the large-scale substrates, wherein said gas delivery element (22) is arranged below each gas nozzle (10) of the treating module (1).

6. Treating module according to one of the preceding claims **characterized in that** the treating module (1) further comprises at least a third bearing retainer strip (9), preferably ball-bearing strip, comprising a plurality of bearings, preferably ball-bearings, for receiving respective exterior ends of transport elements (8) of the transport device, wherein said at least third bearing retainer strip (9) is arranged parallel between the two bearing retainer strips (9).

7. Treating module according to one of the preceding claims **characterized in that** the adjusting device comprises at least a first adjusting element (19) and at least a second adjusting element (20), wherein the first adjusting elements (19) are connected in such a manner to the respective liquid weirs (13) or bearing retainer strips (9) by a plurality of second adjusting elements (20) that the horizontal alignment of said liquid weirs (13) and bearing retainer strips (9) can be adjusted.

8. Treating module according to one of the preceding claims **characterized in that** the adjusting device is arranged below the bottom of the housing (2) of the treating module (1) in a separate area, which is substantially free of treatment liquid.

9. Treating module according to claim 7 **characterized in that** the first adjusting elements (19) are bars or strips, which are forming together a racket as substructure for the treating module (1); wherein the second adjusting elements (20) are bolts, pins or screws; and wherein both adjusting elements (19,20) are preferably made of metal.

10. Treating module according to one of the preceding claims **characterized in that** the treating module (1) further comprises at least a treatment liquid outlet element (18), which is a part of a separated treatment liquid circulation system of the treating module (1).

11. Treating module according to one of the preceding claims **characterized in that** the housing cover (4) comprises a central area (3) and two side areas (5), wherein the central area (3) is aligned parallel to the transport area and comprises at least a gas discharge opening (7); and wherein both side areas (5) running constantly downwards from the central area (3) of the housing cover (4) to the housing (2).

12. Method for treating of large-scale substrates in a horizontal apparatus comprising a plurality of modules **characterized by** the following method steps:
i) Providing a horizontal apparatus comprising at least a pre-treatment module, at least a treating module according to one of claims 1 to 11, and at least a post-treatment module,
ii) Adjusting the transport elements (8) and the liquid weirs (13) of each treating module (1) according to one of claims 1 to 11 by the adjusting device to ensure their precise horizontal alignment,
iii) Providing large-scale substrates, preferably glass substrates,
iv) Transporting said large-scale substrates through the modules of the horizontal apparatus for executing pre-treatment, treatment, and post-treatment.

13. Method according to claim 12 **characterized in that** the treatment of the large-scale substrates during method step iv) in the treating module (1) according to one of claims 1 to 11 is an electroless wet-chemical treatment for depositing a metal, preferably copper, on the surface of the large-scale substrates.

14. Method according to claim 13 **characterized in that** the electroless wet-chemical treatment is executed by immersing the large-scale substrates in the treatment liquid.

15. Use of a treating module according to one of claims 1 to 11 for metal, in particular copper, deposition on large-scale glass substrates, in particular flat panel displays.

## Patentansprüche

1. Behandlungsmodul (1) einer Vorrichtung zur horizontalen nasschemischen Behandlung von großflächigen Substraten, insbesondere Glassubstraten, umfassend ein Gehäuse (2) mit einer Gehäuseabdeckung (4); eine Transportvorrichtung, die eine Vielzahl von Transportelementen (8) zum horizontalen Prozessieren von großflächigen Substraten umfasst, wobei das Behandlungsmodul (1) ferner mindestens eine erste Flüssigkeitsdüse (11) und mindestens eine Gasdüse (10), die oberhalb der Transportebene (17) der großflächigen Substrate am Eingang des Behandlungsmoduls (1) angeordnet sind, und mindestens eine andere erste Flüssigkeitsdüse (11) und mindestens eine andere Gasdüse (10) umfasst, die oberhalb der Transportebene (17) der großflächigen Substrate am Ausgang des Behandlungsmoduls (1) angeordnet sind, um Behandlungsflüssigkeit innerhalb des Behandlungsmoduls (1) anzusammeln, wobei jede Gasdüse (10) weiter außen als die jeweilige erste Flüssigkeitsdüse (11) angeordnet ist; mindestens ein Flüssigkeitswehr (13), das unter jeder ersten Flüssigkeitsdüse (11) unter der Transportebene (17) der großflächigen Substrate angeordnet ist, **dadurch gekennzeichnet, dass**
das Behandlungsmodul (1) ferner mindestens eine Justiervorrichtung zum Justieren der Transportvorrichtung und der Flüssigkeitswehre (13) des Behandlungsmoduls (1) umfasst.

2. Behandlungsmodul nach Anspruch 1, **dadurch gekennzeichnet, dass** das Behandlungsmodul (1) ferner zwei Lagerhalterleisten (9), vorzugsweise Kugellagerleisten umfasst, die eine Vielzahl von Lagern, vorzugsweise Kugellagern, zum Aufnehmen der jeweiligen Außenenden jedes Transportelements (8) der Transportvorrichtung umfassen.

3. Behandlungsmodul nach den Ansprüchen 1 oder 2, **dadurch gekennzeichnet, dass** das Behandlungsmodul (1) ferner mindestens eine zweite Flüssigkeitsdüse (12) umfasst, die oberhalb der Transportebene (17) der großflächigen Substrate zwischen den ersten Flüssigkeitsdüsen (11) angeordnet ist.

4. Behandlungsmodul nach einem der vorhergehenden Ansprüche, **dadurch gekennzeichnet, dass** das Flüssigkeitswehr (13) zwischen zwei angrenzenden Transportelementen (8) des Transportsystems unter der jeweiligen ersten Flüssigkeitsdüse (11) angeordnet ist.

5. Behandlungsmodul nach einem der vorhergehenden Ansprüche, **dadurch gekennzeichnet, dass** das Behandlungsmodul (1) ein Abgabeelement (22) für Gas, vorzugsweise Druckluft, umfasst, das unter der Transportebene (17) der großflächigen Substrate angeordnet ist, wobei das Gasabgabeelement (22) unter jeder Gasdüse (10) des Behandlungsmoduls (1) angeordnet ist.

6. Behandlungsmodul nach einem der vorhergehenden Ansprüche, **dadurch gekennzeichnet, dass** das Behandlungsmodul (1) ferner mindestens eine dritte Lagerhalterleiste (9), vorzugsweise Kugellagerleiste umfasst, die eine Vielzahl von Lagern, vorzugsweise Kugellagern, zum Aufnehmen jeweiliger Außenenden von Transportelementen (8) der Transportvorrichtung umfasst, wobei die mindestens dritte Lagerhalterleiste (9) parallel zwischen den beiden Lagerhalterleisten (9) angeordnet ist.

7. Behandlungsmodul nach einem der vorhergehenden Ansprüche, **dadurch gekennzeichnet, dass** die Justiervorrichtung mindestens ein erstes Justierelement (19) und mindestens ein zweites Justierelement (20) umfasst, wobei die ersten Justierelemente (19) mittels einer Vielzahl von zweiten Justierelementen (20) in einer solchen Weise mit den jeweiligen Flüssigkeitswehren (13) oder Lagerhalterleisten (9) verbunden sind, dass die horizontale Ausrichtung der Flüssigkeitswehre (13) und Lagerhalterleisten (9) justiert werden kann.

8. Behandlungsmodul nach einem der vorhergehenden Ansprüche, **dadurch gekennzeichnet, dass** die Justiervorrichtung unter dem Boden des Gehäuses (2) des Behandlungsmoduls (1) in einem separaten Bereich angeordnet ist, der im Wesentlichen frei von Behandlungsflüssigkeit ist.

9. Behandlungsmodul nach Anspruch 7, **dadurch gekennzeichnet, dass** die ersten Justierelemente (19) Stäbe oder Leisten sind, die zusammen ein Gestell als Teilstruktur für das Behandlungsmodul (1) bilden; wobei die zweiten Justierelemente (20) Bolzen, Stifte oder Schrauben sind; und wobei beide Justierelemente (19, 20) vorzugsweise aus Metall sind.

10. Behandlungsmodul nach einem der vorhergehenden Ansprüche, **dadurch gekennzeichnet, dass** das Behandlungsmodul (1) ferner mindestens ein Auslasselement (18) für Behandlungsflüssigkeit umfasst, das ein Teil eines getrennten Behandlungsflüssigkeitsumlaufsystems des Behandlungsmoduls (1) ist.

11. Behandlungsmodul nach einem der vorhergehenden Ansprüche, **dadurch gekennzeichnet, dass** die Gehäuseabdeckung (4) einen Zentralbereich (3) und zwei Seitenbereiche (5) umfasst, wobei der Zentralbereich (3) parallel zu dem Transportbereich ausgerichtet ist und mindestens eine Gasablassöffnung (7) umfasst; und wobei beide Seitenbereiche (5) konstant abwärts von dem Zentralbereich (3) der Gehäuseabdeckung (4) zu dem Gehäuse (2) verlaufen.

12. Verfahren zur Behandlung großflächiger Substrate in einer horizontalen Vorrichtung, die eine Vielzahl von Modulen umfasst, wobei das Verfahren durch die folgenden Schritte gekennzeichnet ist:
i) Bereitstellen einer horizontalen Vorrichtung, die mindestens ein Vorbehandlungsmodul, mindestens ein Behandlungsmodul gemäß einem der Ansprüche 1 bis 11 und mindestens ein Nachbehandlungsmodul umfasst,
ii) Justieren der Transportelemente (8) und der Flüssigkeitswehre (13) jedes Behandlungsmoduls (1) gemäß einem der Ansprüche 1 bis 11 durch die Justiervorrichtung, um ihre präzise horizontale Ausrichtung zu gewährleisten,
iii) Bereitstellen großflächiger Substrate, vorzugsweise Glassubstrate,
iv) Transportieren der großflächigen Substrate durch die Module der horizontalen Vorrichtung zum Durchführen von Vorbehandlung, Behandlung und Nachbehandlung.

13. Verfahren nach Anspruch 12, **dadurch gekennzeichnet, dass** die Behandlung der großflächigen Substrate während des Schritts iv) des Verfahrens in dem Behandlungsmodul (1) gemäß einem der Ansprüche 1 bis 11 eine stromlose nasschemische Behandlung zum Abscheiden eines Metalls, vorzugsweise Kupfer, auf der Oberfläche der großflächigen Substrate ist.

14. Verfahren nach Anspruch 13, **dadurch gekennzeichnet, dass** die stromlose nasschemische Behandlung durchgeführt wird, indem die großflächigen Substrate in die Behandlungsflüssigkeit getaucht werden.

15. Verwendung eines Behandlungsmoduls gemäß einem der Ansprüche 1 bis 11 zur Abscheidung von Metall, insbesondere Kupfer, auf großflächigen Glassubstraten, insbesondere Flachbildschirmen.

## Revendications

1. Module de traitement (1) d'un appareil de traitement chimique humide horizontal de substrats de grande taille, en particulier de substrats de verre, comprenant un boîtier (2) avec un couvercle de boîtier (4) ; un dispositif de transport comprenant une pluralité d'éléments de transport (8) pour le traitement horizontal de substrats de grande taille, le module de traitement (1) comprenant en outre au moins une première buse de liquide (11) et au moins une buse de gaz (10) disposées au-dessus du niveau de transport (17) des substrats de grande taille à l'entrée du module de traitement (1) et au moins une autre première buse de liquide (11) et au moins une autre buse de gaz (10) disposées au-dessus du niveau de transport (17) des substrats de grande taille à la sortie du module de traitement (1) pour accumuler du liquide de traitement à l'intérieur du module de traitement (1), chaque buse de gaz (10) étant disposée plus à l'extérieur que la première buse de liquide respective (11) ; au moins un déversoir de liquide (13) disposé au-dessous de chaque première buse de liquide (11) au-dessous du niveau de transport (17) des substrats de grande taille ; **caractérisé en ce que**
le module de traitement (1) comprend en outre au moins un dispositif de réglage pour régler le dispositif de transport et les déversoirs de liquide (13) du module de traitement (1).

2. Module de traitement selon la revendication 1 **caractérisé en ce que** le module de traitement (1) comprend en outre deux bandes de retenue de roulements (9), de préférence des bandes de roulements à billes, comprenant une pluralité de roulements, de préférence de roulements à billes, pour recevoir les extrémités extérieures respectives de chaque élément de transport (8) du dispositif de transport.

3. Module de traitement selon les revendications 1 ou 2 **caractérisé en ce que** le module de traitement (1) comprend en outre au moins une deuxième buse de liquide (12) disposée au-dessus du niveau de transport (17) des substrats de grande taille entre les premières buses de liquide (11).

4. Module de traitement selon une des revendications précédentes **caractérisé en ce que** le déversoir de liquide (13) est disposé entre deux éléments de transport adjacents (8) du système de transport au-dessous de la première buse de liquide respective (11).

5. Module de traitement selon une des revendications précédentes **caractérisé en ce que** le module de traitement (1) comprend un élément de distribution de gaz, de préférence d'air comprimé (22), disposé au-dessous du niveau de transport (17) des substrats de grande taille, ledit élément de distribution de gaz (22) étant disposé au-dessous de chaque buse de gaz (10) du module de traitement (1).

6. Module de traitement selon une des revendications précédentes **caractérisé en ce que** le module de traitement (1) comprend en outre au moins une troisième bande de retenue de roulements (9), de préférence une bande de roulements à billes, comprenant une pluralité de roulements, de préférence de roulements à billes, pour recevoir des extrémités extérieures respectives d'éléments de transport (8) du dispositif de transport, ladite au moins troisième bande de retenue de roulements (9) étant disposée parallèlement entre les deux bandes de retenue de roulements (9).

7. Module de traitement selon une des revendications précédentes **caractérisé en ce que** le dispositif de réglage comprend au moins un premier élément de réglage (19) et au moins un deuxième élément de réglage (20), les premiers éléments de réglage (19) étant reliés aux déversoirs de liquide (13) ou bandes de retenue de roulements (9) respectifs par une pluralité de deuxièmes éléments de réglage (20) de telle sorte que l'alignement horizontal desdits déversoirs de liquide (13) et bandes de retenue de roulements (9) peut être réglé.

8. Module de traitement selon une des revendications précédentes **caractérisé en ce que** le dispositif de réglage est disposé au-dessous du fond du boîtier (2) du module de traitement (1) dans une zone séparée, qui est sensiblement dépourvue de liquide de traitement.

9. Module de traitement selon la revendication 7 **caractérisé en ce que** les premiers éléments de réglage (19) sont des barres ou des bandes, qui forment ensemble une raquette en tant que sous-structure pour le module de traitement (1) ; les deuxièmes éléments de réglage (20) étant des boulons, des broches ou des vis ; et les deux éléments de réglage (19, 20) étant de préférence constitués de métal.

10. Module de traitement selon une des revendications précédentes **caractérisé en ce que** le module de traitement (1) comprend en outre au moins un élément de sortie de liquide de traitement (19), qui est une partie d'un système de circulation de liquide de traitement séparé du module de traitement (1).

11. Module de traitement selon une des revendications précédentes **caractérisé en ce que** le couvercle de boîtier (4) comprend une zone centrale (3) et deux zones latérales (5), la zone centrale (3) étant alignée parallèlement à la zone de transport et comprenant au moins une ouverture d'évacuation de gaz (7) ; et les deux zones latérales (5) allant constamment vers le bas depuis la zone centrale (3) du couvercle de boîtier (4) jusqu'au boîtier (2).

12. Procédé de traitement de substrats de grande taille dans un appareil horizontal comprenant une pluralité de modules **caractérisé par** les étapes de procédé suivantes :
i) se procurer un appareil horizontal comprenant au moins un module de prétraitement, au moins un module de traitement selon une des revendications 1 à 11, et au moins un module de post-traitement,
ii) régler les éléments de transport (8) et les déversoirs de liquide (13) de chaque module de traitement (1) selon une des revendications 1 à 11 avec le dispositif de réglage pour assurer leur alignement horizontal précis,
iii) se procurer des substrats de grande taille, de préférence des substrats de verre,
iv) transporter lesdits substrats de grande taille à travers les modules de l'appareil horizontal pour exécuter un prétraitement, un traitement, et un post-traitement.

13. Procédé selon la revendication 12 **caractérisé en ce que** le traitement des substrats de grande taille pendant l'étape de procédé iv) dans le module de traitement (1) selon une des revendications 1 à 11 est un traitement chimique humide sans courant pour déposer un métal, de préférence du cuivre, sur la surface des substrats de grande taille.

14. Procédé selon la revendication 13 **caractérisé en ce que** le traitement chimique humide sans courant est exécuté en plongeant les substrats de grande taille dans le liquide de traitement.

15. Utilisation d'un module de traitement selon une des revendications 1 à 11 pour le dépôt de métal, en particulier de cuivre, sur des substrats de grande taille, en particulier des écrans plats.
